# FASCICULE DE BREVET EUROPEEN

(11) **EP 0 901 206 B1**
(45) Date de publication et mention de la délivrance du brevet: **09.10.2002**
(21) Numéro de dépôt: 98402100.6
(22) Date de dépôt: 24.08.1998
(51) Int. Cl.: H01S 5/50

(54) **Dispositif préamplificateur optique**
Optischer Vorverstärker
Optical preamplifier

(30) Priorité: 04.09.1997 FR 9711005
(43) Date de publication de la demande: 10.03.1999
(73) Titulaire: ALCATEL, 75008 Paris (FR)
(72) Inventeur: Ducellier, Thomas, Ottawa, Ontario, K1N 6B9 (CA); Hebert, Jean-Paul, 78470 Saint Remy Les Chevreuse (FR); Goix, Michel, 91700 Saint Genevieve Des Bois (FR)
(74) Mandataire: Smith, Bradford Lee

(56) Documents cités:
- EP-A- 0 639 876
- EP-A- 0 762 580
- FR-A- 2 737 585
- US-A- 5 264 960
- MIKKELSEN B ET AL: "HIGH PERFORMANCE SEMICONDUCTOR OPTICAL AMPLIFIERS AS IN-LINE- AND PRE-AMPLIFIERS" PROCEEDINGS OF THE EUROPEAN CONFERENCE ON OPTICAL COMMUNICATION (EC, FIRENZE, SEPT. 25 - 29, 1994, vol. VOL. 2, no. CONF. 20, 25 septembre 1994, pages 710-713, XP000619632 ISTITUTO INTERNAZIONALE DELLE COMUNICAZIONI
- SOULAGE G ET AL: "CLAMPED GAIN TRAVELLING WAVE SEMICONDUCTOR OPTICAL AMPLIFIER AS A LARGE DYNAMIC RANGE OPTICAL GATE" PROCEEDINGS OF THE EUROPEAN CONFERENCE ON OPTICAL COMMUNICATION (EC, FIRENZE, SEPT. 25 - 29, 1994, vol. VOL. 1, no. CONF. 20, 25 septembre 1994, pages 451-453, XP000619584 ISTITUTO INTERNAZIONALE DELLE COMUNICAZIONI
- DOUSSIERE P ET AL: "CLAMPED GAIN TRAVELLING WAVE SEMICONDUCTOR OPTICAL AMPLIFIER FOR WAVELENGTH DIVISION MULTIPLEXING APPLICATIONS" PROCEEDINGS OF THE INTERNATIONAL SEMICONDUCTOR LASER CONFERENCE, MAUI, HAWAII, SEPT. 19 - 23, 1994, no. CONF. 14, 19 septembre 1994, page 185/186 XP000514864 INSTITUTE OF ELECTRICAL AND ELECTRONICS ENGINEERS
- STUBJKAER K. ET AL.: 'Semi-conductor optical amplifiers as linear amplifiers, gates and wavelength converters' PROCEEDINGS OF THE EUROPEAN CONFERENCE ON OPTICAL COMMUNICATION (EC. MONTREUX, INVITED PAPERS, SWISS ELECTRONICAL ASSOCIATION) vol. 1, 12 Septembre 1993 - 16 Septembre 1993, MONTREUX, SWITZERLAND, pages 60 - 67

## Description

L'invention concerne un dispositif préamplificateur optique. Elle s'applique aux télécommunications optiques et notamment aux récepteurs à haut débit et à grande sensibilité.

On utilise la préamplification optique, notamment dans les récepteurs à hauts débits pour amplifier le signal dans le domaine optique plutôt que de l'amplifier dans le domaine électrique.

Ceci a pour avantage principal d'avoir un amplificateur très faible bruit car l'amplification optique repose sur des mouvements photoniques procurant du bruit quantique alors que l'amplification électrique repose sur des mouvements d'électrons procurant du bruit thermique plus important.

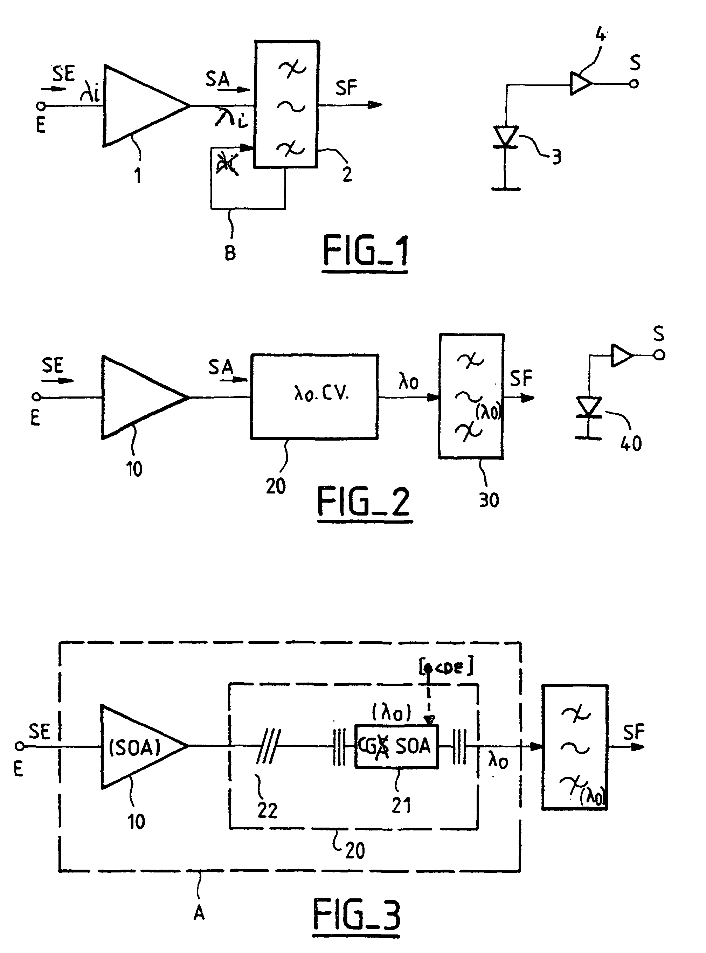

Le schéma d'un dispositif préamplificateur optique pour récepteur selon l'état de la technique est représenté sur la figure 1.

Il comporte une entrée E pour le signal incident optique SE et une sortie S délivrant le signal détecté et amplifié. L'entrée E est reliée à un premier amplificateur optique 1 qui est soit un amplificateur optique semi-conducteur (Semi-conductor Optical Amplifier (SOA) en terminologie anglo-saxonne), soit un amplificateur à fibre dopée à l'erbium (Erbium-Doped Fiber Amplifier (EDFA) en terminologie anglo-saxonne).

Cet amplificateur est suivi d'un filtre passe-bande 2. Le filtre est accordé par une boucle d'accord B à la longueur d'onde λᵢ du signal incident SE.

Ce filtre 2 est un filtre accordable et accordé par la boucle en fonction de la longueur d'onde λᵢ pour laisser passer le signal amplifié SA sans le bruit large bande généré par l'amplificateur 1 (EDFA).

Le signal amplifié filtré SF est détecté par un photodétecteur tel qu'une photodiode 3, puis éventuellement amplifié électriquement 4 dans le récepteur.

Le problème rencontré par un tel dispositif d'amplification réside dans le fait que le filtre passe-bande doit être accordé à la longueur d'onde λᵢ du signal.

En pratique, il est donc nécessaire d'avoir un filtre accordable. L'utilisation de tels filtres soulève de nombreuses difficultés : complexité de réalisation, coût élevé, mais aussi les nombreux problèmes que peut entraîner une mauvaise stabilité de l'accord.

En effet, on utilise pour cela des filtres complexes possédant des boucles de contre-réaction qui permettent auxdits filtres de rester calés sur la longueur d'onde du signal incident, mais ces filtres sont coûteux et difficiles à réaliser techniquement.

Afin de résoudre ce problème il est proposé un dispositif préamplificateur optique pour photorécepteur comportant un premier amplificateur optique et principalement caractérisé en ce que ledit premier amplificateur optique est couplé à un photodétecteur par l'intermédiaire d'un dispositif à conversion de longueur d'onde à une longueur d'onde λ₀ fixe et d'un filtre optique centré autour de ladite longueur d'onde fixe λ₀.

Selon une autre caractéristique de l'invention le dispositif à conversion de longueur d'onde comprend un amplificateur optique semi-conducteur à gain stabilisé, la longueur d'onde de conversion λ₀ étant la longueur d'onde d'oscillation λ₀ générée par ledit amplificateur à gain stabilisé, l'entrée de cet amplificateur étant reliée à la sortie du premier amplificateur optique à travers un filtre optique réjecteur pour ladite longueur d'onde d'oscillation.

Selon une autre caractéristique de l'invention le filtre réjecteur est un filtre à réseau incliné.

Selon une autre caractéristique de l'invention, le premier amplificateur optique est également un amplificateur optique semi-conducteur.

L'utilisation d'amplificateurs optiques semi-conducteurs permet de réduire l'encombrement du dispositif préamplificateur puisqu'un amplificateur optique à semi-conducteur est plus compact qu'un amplificateur à fibre optique dopé à l'erbium (EDFA). Ce choix permet en outre de réduire la consommation énergétique du dispositif.

D'autres caractéristiques et avantages de l'invention apparaîtront à la lecture de la description suivante qui est donnée à titre d'exemple non limitatif et qui est faite en regard des dessins sur lesquels :
- la figure 1, représente le schéma d'un dispositif selon l'art antérieur,
- la figure 2, représente un schéma général de l'invention,
- la figure 3, représente le schéma d'un mode préféré de réalisation.

Le dispositif préamplificateur optique selon l'invention comporte un premier amplificateur 10 dont l'entrée E reçoit un signal incident SE de longueur d'onde λi quelconque dans la bande de transmission des télécommunications optiques.

La sortie de l'amplificateur 10 est reliée à l'entrée d'un dispositif convertisseur de longueur d'onde 20. Ce dispositif est apte à convertir le signal incident amplifié SA à une longueur d'onde auxiliaire λ₀ prédéfinie. Le signal à la longueur d'onde auxiliaire λ₀ est appliqué à l'entrée d'un filtre optique 30 passe-bande centré autour d'une longueur d'onde fixe qui est la longueur d'onde λ₀.

Le signal converti à la longueur d'onde λ₀ est filtré par le filtre optique 30 à longueur d'onde fixe puis détecté par une photodiode 40.

La conversion en longueur d'onde du signal incident permet de rendre le dispositif préamplificateur optique indépendant de la longueur d'onde du signal incident, et par conséquent permet d'utiliser un filtre optique à longueur d'onde fixe.

Un mode préféré de réalisation de l'invention est représenté sur la figure 3. Il permet l'intégration des différentes fonctions du dispositif préamplificateur et par conséquent la réalisation d'un composant de faible encombrement par rapport aux solutions de l'état de la technique, un composant de quelques cm³ (2 cm³) au lieu d'une carte électronique d'une dizaine de cm². Ceci est particulièrement avantageux dans le cas de l'utilisation de plusieurs dispositifs comme celui-ci dans les applications de réception de signaux multiplexés en longueur d'onde (Wavelength Division Multiplexing, WDM).

Ce mode de réalisation consiste à utiliser comme convertisseur de longueur d'onde, un amplificateur optique semi-conducteur à gain stabilisé (Clamped Gain Semi-conductor Optical Amplifier en terminologie anglo-saxonne, CG-SOA) et à placer en entrée de cet amplificateur 21 un isolateur 22 pour rejeter l'oscillation retour générée par l'amplificateur 21.

Comme cela est précisé dans la suite, l'isolateur 22 peut être réalisé par un filtre réjecteur qui lui-même, selon un mode préféré de réalisation permettant l'intégration, est réalisé par un réseau incliné.

En effet, on rappelle qu'un amplificateur optique semi-conducteur à gain stabilisé est un amplificateur dans lequel on crée une rétroaction de façon à ce qu'une cavité laser se mette en place autour du milieu amplificateur pour qu'une oscillation se produise à l'intérieur de cette cavité à une longueur d'onde prédéfinie. La longueur d'onde d'oscillation est prédéfinie par construction lors de la réalisation de l'amplificateur. On trouvera une description plus détaillée d'un tel amplificateur par exemple dans les demandes de brevet EP-A-0 639 876 et EP-A-0 762 580.

Pour supprimer la propagation de l'oscillation retour vers l'amplificateur 10, évitant ainsi la saturation de cet amplificateur, il est prévu que l'isolateur placé entre l'amplificateur 10 et l'amplificateur à gain stabilisé soit réalisé par un filtre optique réjecteur pour la longueur d'onde d'oscillation λ₀.

Toujours dans le but de rendre le dispositif intégrable, on choisit de réaliser le filtre réjecteur au moyen d'un réseau incliné. La technologie de réalisation d'un tel réseau est bien connue et permet d'obtenir par construction, un affaiblissement du signal à la longueur d'onde désirée.

Ainsi , selon ce mode préféré de réalisation le dispositif préamplificateur pour récepteur comporte deux étages préamplificateurs optiques semi-conducteurs intégrés, un filtre optique à longueur d'onde fixe, et une photodiode. Les deux étages d'amplification sont l'un réalisé par le premier amplificateur optique semi-conducteur faible bruit (SOA), l'autre par un amplificateur optique semi-conducteur à gain stabilisé (CG-SOA) avec une réjection de l'oscillation retour de cette amplificateur évitant toute saturation du premier amplificateur optique.

Le signal SE est fortement amplifié par l'amplificateur (SOA) 10 faible bruit et à grand gain. Puis, il est converti à la longueur d'onde d'oscillation λ₀, de l'amplificateur à gain stabilisé 21 (CG-SOA), laquelle est choisie de manière à être inférieure aux longueurs d'ondes de la fenêtre de transmission de la ligne (par exemple 1510 nm).

Le signal converti est ensuite filtré par un filtre à longueur d'onde fixe puis détecté par une photodiode.

Cette solution permet donc une intégration des deux étages d'amplification sur substrat en phosphure d'indium (InP, référence A sur la figure 3).

Cette solution présente également comme autres avantages de procurer un taux d'extinction amélioré et d'améliorer le rapport signal à bruit optique (de 15 dB à un rapport signal à bruit supérieur à 30 dB).

On rappelle que le rapport signal à bruit et le taux d'extinction sont des paramètres permettant de définir la qualité d'un signal optique.

En outre, l'amplificateur optique semi-conducteur à gain stabilisé du dispositif peut être utilisé en tant que porte optique, commandée soit électriquement, soit optiquement, pour réaliser un démultiplexage ou un échantillonnage temporel des signaux optiques.

A cette fin, un circuit CDE de commande du gain de l'amplificateur sera relié à l'amplificateur pour piloter son gain. Ce circuit pourra par exemple être un circuit de modulation du courant de gain de l'amplificateur.

## Revendications

1. Dispositif préamplificateur optique pour photorécepteur comportant un premier amplificateur optique (10), un filtre optique passe-bande (30) et un photodétecteur (40), **caractérisé en ce que** ledit premier amplificateur optique (10) conserve la longueur d'onde du signal optique amplifié et est couplé au photodétecteur (40) par l'intermédiaire d'un dispositif optique à conversion de longueur d'onde (20) à une longueur d'onde λ₀ fixe et ledit filtre optique passe-bande (30) est centré autour de ladite longueur d'onde fixe λ₀.

2. Dispositif préamplificateur selon la revendication 1, **caractérisé en ce que** le dispositif optique à conversion de longueur d'onde (20) comprend un amplificateur optique semi-conducteur à gain stabilisé (21), la longueur d'onde de conversion λ₀ étant la longueur d'onde d'oscillation λ₀ générée par ledit amplificateur (21), l'entrée de cet amplificateur étant reliée à la sortie du premier amplificateur optique (10) à travers un filtre optique réjecteur (22) pour ladite longueur d'onde d'oscillation.

3. Dispositif préamplificateur selon la revendication 2, **caractérisé en ce que** le filtre optique réjecteur (22) est un filtre à réseau incliné.

4. Dispositif préamplificateur selon l'une quelconque des revendications précédentes, **caractérisé en ce que** le premier amplificateur optique (10) est également un amplificateur optique semi - conducteur.

5. Dispositif préamplificateur selon les revendications 1 ou 2, **caractérisé en ce que** l'amplificateur optique semi-conducteur du dispositif de conversion est commandé électriquement ou optiquement (CDE) de manière à réaliser une porte optique.

## Patentansprüche

1. Optischer Vorverstärker für einen Photorezeptor, mit einem ersten optischen Verstärker (10), einem optischen Bandpassfilter (30) und einem Photodetektor, **dadurch gekennzeichnet, dass** der erste optische Verstärker (10) die Wellenlänge des optischen Signals beibehält und an den Photodetektor über eine optische Vorrichtung (20) zur Wellenlängenkonversion auf eine feste Wellenlänge λ₀ gekoppelt ist und das optische Bandpassfilter (30) um die feste Wellenlänge λ₀ zentriert ist.

2. Vorverstärkervorrichtung nach Anspruch 1, **dadurch gekennzeichnet, dass** die optische Vorrichtung (20) zur Wellenlängenkonversion einen optischen Halbleiterverstärker mit stabilisierter Verstärkung (21) umfasst, dass die Konversionswellenlänge λ₀ die von dem Verstärker (21) erzeugte Oszillationswellenlänge λ₀ ist, und der Eingang dieses Verstärkers mit dem Ausgang des ersten optischen Verstärkers (10) über ein optisches Unterdrückungsfilter (22) für die Oszillationswellenlänge verbunden ist.

3. Vorverstärkervorrichtung nach Anspruch 2, **dadurch gekennzeichnet, dass** das optische Unterdrückungsfilter (22) ein Filter mit schrägem Gitter ist.

4. Vorverstärkervorrichtung nach einem beliebigen der vorhergehenden Ansprüche, **dadurch gekennzeichnet, dass** der erste optische Verstärker (10) ebenfalls ein optischer Halbleiterverstärker ist.

5. Vorverstärkervorrichtung nach einem der Ansprüche 1 oder 2, **dadurch gekennzeichnet, dass** der optische Halbleiterverstärker der Konversionsvorrichtung elektrisch oder optisch gesteuert ist (CDE), um ein optisches Gatter zu bilden.

## Claims

1. An optical preamplifier device for a light receiver, the device including a first optical amplifier (10), a band-pass optical filter (30), and a photodetector (40), said optical preamplifier device being **characterized in that** said first optical amplifier (10) conserves the wavelength of the amplified optical signal and is coupled to the photodetector (40) via an optical wavelength-conversion device (20) for converting wavelength to a fixed wavelength λₒ, and said band-pass optical filter (30) is centered around said fixed wavelength λₒ.

2. A preamplifier device according to claim 1, **characterized in that** the optical wavelength-conversion device (20) comprises a clamped gain semiconductor optical amplifier (21), the conversion wavelength λₒ being the oscillation wavelength λₒ generated by said amplifier (21), the input of the amplifier being connected to the output of the first optical amplifier (10) via an optical stop filter (22) for stopping said oscillation wavelength.

3. A preamplifier device according to claim 2, **characterized in that** the optical stop filter (22) is a sloping-grating filter.

4. A preamplifier device according to any preceding claim, **characterized in that** the first optical amplifier (10) is also a semiconductor optical amplifier.

5. A preamplifier device according to claim 1 or claim 2, **characterized in that** the semiconductor optical amplifier of the conversion device is electrically or optically controlled (CDE) so as to form an optical gate.
